(19) Europäisches Patentamt
European Patent Office
Office européen des brevets

(11) **EP 3 516 769 B1**

(12) **FASCICULE DE BREVET EUROPEEN**

(45) Date de publication et mention de la délivrance du brevet:
**18.11.2020 Bulletin 2020/47**

(21) Numéro de dépôt: **17772049.7**

(22) Date de dépôt: **25.09.2017**

(51) Int Cl.:
*H03K 5/15* $^{(2006.01)}$       *G01S 13/00* $^{(2006.01)}$

(86) Numéro de dépôt international:
**PCT/EP2017/074167**

(87) Numéro de publication internationale:
**WO 2018/055149 (29.03.2018 Gazette 2018/13)**

(54) **DISPOSITIF DE GÉNÉRATION D'UN SIGNAL PORTEUR CONTINU À PARTIR D'UN SIGNAL IMPULSIONNEL DE RÉFÉRENCE**

VORRICHTUNG ZUR ERZEUGUNG EINES KONTINUIERLICHEN TRÄGERSIGNALS VON EINEM REFERENZIMPULSSIGNAL

DEVICE FOR GENERATING A CONTINUOUS CARRIER SIGNAL FROM A REFERENCE PULSE SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2016 FR 1601398**

(43) Date de publication de la demande:
**31.07.2019 Bulletin 2019/31**

(73) Titulaire: **Thales**
**92400 Courbevoie (FR)**

(72) Inventeurs:
• **JAHAN, Daniel**
**29200 Brest (FR)**
• **CHAPUIS, Patrick**
**78851 Elancourt Cedex (FR)**

(74) Mandataire: **Lavoix**
**2, place d'Estienne d'Orves**
**75441 Paris Cedex 09 (FR)**

(56) Documents cités:
WO-A1-2012/038734       US-A- 3 299 427
US-A- 4 529 984       US-A- 5 659 320

**Description**

L'invention a pour domaine celui des dispositifs de génération d'un signal continu à partir d'un signal impulsionnel. L'invention a plus particulièrement pour domaine celui de la génération d'un signal sinusoïdal continu à partir d'un signal sinusoïdal impulsionnel, de manière à ce que le signal continu obtenu soit cohérent en phase avec le signal impulsionnel d'origine.

Dans la présente demande de brevet, par « signal impulsionnel », on entend un signal, notamment sinusoïdal, modulé en amplitude par impulsion de manière à présenter des impulsions séparées se succédant dans le temps avec une période de répétition ou récurrence. Ces impulsions constituent la partie utile du signal impulsionnel. Toutefois, à ce dernier, est superposé un bruit de fond tout le temps.

Le besoin de générer un signal continu se rencontre typiquement dans le domaine des radars, où le signal continu obtenu peut servir de porteuse à une modulation appropriée pour brouiller des radars cohérents, dits Pulse-Doppler.

D'une façon générale, le traitement du signal radar a pour but de faire ressortir, dans les signaux de retour, les échos du bruit de fond. Cela passe notamment par des intégrations appropriées à la forme d'onde radar employée.

C'est ainsi que les concepteurs de radars ont développé l'intégration cohérente en phase, ce qui permet au passage de mesurer la vitesse par effet Doppler, et la compression d'impulsion.

C'est ainsi que, pour concevoir des brouilleurs de puissance raisonnable, il a fallu faire des générateurs de signal de brouillage cohérent avec le signal à brouiller et, en particulier, cohérent en phase.

Pour ce faire, des dispositifs à ligne-à-retard (LAR dans ce qui suit) ont vu le jour, utilisant la propriété de mémorisation du signal impulsionnel analogique dans une LAR analogique et en réalisant une recirculation du signal impulsionnel dans cette LAR pour conserver le signal durant un temps supérieur à celui du retard introduit par la LAR. Mais ces dispositifs analogiques se sont révélés compliqués et peu performants en raison du système de gestion à commutateurs de la recirculation et de la faiblesse des temps de mémorisation possibles sans perte ni altération du rapport signal à bruit.

L'électronique numérique apparaissant, les concepteurs ont rapidement envisagé d'utiliser une mémorisation numérique aux performances sans communes mesures avec celles de la mémorisation analogique. Les concepteurs ont ainsi inventé les mémoires numériques de fréquence ou DRFM (selon l'abréviation anglaise « Digital RadioFrequency Memory »). Aujourd'hui, tous les brouilleurs conçus utilisent des DRFM.

D'une façon générale, pour former un signal sinusoïdal continu, du moins durant une récurrence (ou période de répétition des impulsions - PRI), à partir d'un signal sinusoïdal impulsionnel, de durée LI (largeur d'impulsion), une DRFM enregistre l'impulsion et la rejoue autant de fois qu'il est nécessaire pour remplir la récurrence jusqu'à la prochaine impulsion reçue. Les brouilleurs sont alors dits cohérents car, par simple mémorisation du signal à brouiller, ils sont capables de rejouer un signal de brouillage à base de répliques du signal à brouiller, donc rigoureusement cohérent.

Toutefois, ce rejeu complique la gestion et le séquencement de la mémoire, d'autant que les DRFM ne sont pas que de simples mémoires : elles possèdent également des fonctions de traitements mathématiques pour transformer le signal impulsionnel incident de façon appropriée pour réaliser l'effet souhaité et des fonctions de séquencement et de gestion assez sophistiquées pour perdre le minimum de temps.

En conséquence, ces DRFM sont des dispositifs donnant satisfaction sur le plan technique, mais dont la sophistication aboutit à des coûts prohibitifs pour certaines applications considérées comme consommables. On connaît aussi un dispositif d'inter-corrélation temporelle continue pour un Radar à corrélation croisée en temps continu à grande vitesse, à faible consommation d'énergie, décrit dans l'application PCT WO 2012038734 A1.

Le but de la présente invention est donc de résoudre ces problèmes, notamment de proposer une alternative notamment à l'utilisation de DRFM.

Pour cela l'invention a pour objet un dispositif de génération d'un signal porteur (p(t)) à partir d'un signal impulsionnel incident, ledit signal impulsionnel incident comportant des impulsions périodiques caractérisées par une largeur d'impulsion et une période de répétition, le dispositif comportant :

- un module d'analyse propre à générer un signal binaire de détection de l'impulsion dans le signal impulsionnel incident, ledit signal impulsionnel incident étant appliqué en entrée dudit module d'analyse ;
- un multiplieur propre à pondérer le signal impulsionnel incident par le signal binaire pour obtenir un signal impulsionnel pondéré ne possédant plus de bruit hors impulsion ;
- une ligne à retard comportant K modules de retard disposés en série les uns des autres, chaque module de retard étant propre à retarder un signal impulsionnel d'entrée, appliqué en entrée dudit module de retard, pour délivrer un signal impulsionnel de sortie correspondant au signal impulsionnel d'entrée retardé d'une largeur d'impulsion, le signal impulsionnel d'entrée appliqué en entrée du premier module de retard de la ligne à retard correspondant au signal impulsionnel pondéré délivré en sortie du multiplieur, et le nombre K de modules de retard étant égal à la partie entière de la période de répétition divisée par la largeur d'impulsion, diminuée d'une unité ; et,

- un sommateur propre à sommer le signal impulsionnel pondéré en sortie du multiplieur et les K signaux impulsionnels de sortie des K modules de retard de la ligne de retard pour obtenir le signal porteur.

De préférence ce dispositif est tel que la ligne à retard comporte :

- une pluralité de N cellules élémentaires montées en série les unes des autres, chaque cellule élémentaire étant propre à introduire un retard élémentaire dans un signal d'entrée appliqué en entrée de ladite cellule élémentaire pour délivrer en sortie un signal de sortie retardé ; et,
- une pluralité de N multiplieurs, le multiplieur de rang n, n étant un nombre entier entre 1 et N, permettant de multiplier le signal de sortie de la cellule élémentaire de rang n de la ligne à retard par un coefficient d'une pluralité de N coefficients, chaque coefficient étant déterminé par le module d'analyse à partir du signal impulsionnel incident de manière à regrouper les cellules élémentaires pour former lesdits K modules de retard de la ligne de retard.

L'invention a également pour objet un dispositif de génération d'un signal porteur à partir d'un signal impulsionnel incident, ledit signal impulsionnel incident comportant des impulsions périodiques caractérisées par une largeur et une période de répétition, le dispositif comportant :

- un module d'analyse propre à générer un signal binaire de détection de l'impulsion dans le signal impulsionnel incident, ledit signal impulsionnel incident étant appliqué en entrée dudit module d'analyse ;
- une première ligne à retard dédiée au signal impulsionnel incident et comportant K modules de retard disposés en série les uns des autres, chaque module de retard étant propre à retarder un signal impulsionnel d'entrée, appliqué en entrée dudit module de retard, pour délivrer un signal impulsionnel de sortie, en sortie dudit module de retard, correspondant au signal impulsionnel d'entrée retardé d'une largeur d'impulsion, le signal impulsionnel d'entrée appliqué en entrée du premier module de retard de la première ligne de retard correspondant au signal impulsionnel incident, et le nombre K de modules de retard étant égal à la partie entière de la période de répétition divisée par la largeur d'impulsion, diminuée d'une unité ;
- une seconde ligne de retard dédiée au signal binaire et comportant K modules de retard disposés en série les uns des autres, chaque module de retard étant propre à retarder un signal binaire d'entrée, appliqué en entrée dudit module de retard, pour délivrer un signal binaire de sortie, en sortie dudit module de retard, correspondant au signal binaire d'entrée retardé de la largeur d'impulsion, le signal binaire d'entrée appliqué en entrée du premier module de retard de la seconde ligne de retard correspondant au signal binaire délivré par le module d'analyse ;
- un multiplieur de rang 0 propre à pondérer le signal impulsionnel incident par le signal binaire pour obtenir un signal impulsionnel pondéré n'ayant pas de bruit hors impulsion ;
- une pluralité de multiplieurs, le multiplieur de rang k, k étant un nombre entier entre 1 et K, propre à pondérer le signal impulsionnel de sortie délivré en sortie du module de retard de rang k de la première ligne de retard par le signal binaire de sortie délivré en sortie du module de retard de rang k de la seconde ligne de retard, pour obtenir des signaux impulsionnels pondérés retardés n'ayant pas de bruit hors impulsion ; et,
- un sommateur propre à sommer le signal impulsionnel pondéré en sortie du multiplieur de rang 0 et les K signaux impulsionnel pondérés retardés en sortie des K multiplieurs de rang k pour obtenir le signal porteur continu.

De préférence ce dispositif est tel que chaque ligne à retard comporte :

- une pluralité de N cellules élémentaires montées en série les unes des autres, chaque cellule élémentaire étant propre à introduire un retard élémentaire dans un signal d'entrée, appliqué en entrée de ladite cellule élémentaire, pour délivrer un signal de sortie, en sortie de ladite cellule élémentaire, retardé ; et,
- une pluralité de N multiplieurs, le multiplieur de rang n, n étant un nombre entier entre 1 et N, permettant de multiplier le signal impulsionnel de sortie de la cellule élémentaire de rang n de la première ligne de retard par le signal binaire de sortie de la cellule élémentaire de rang n de la seconde ligne de retard et par un coefficient d'une pluralité de N coefficients, chaque coefficient étant déterminé par le module d'analyse à partir du signal impulsionnel incident de manière à former lesdits K modules de retard à partir des cellules élémentaires des lignes de retard.

Suivant des modes particuliers de réalisation, l'un ou l'autre de ces dispositifs comporte une ou plusieurs des caractéristiques suivantes, prises isolément ou suivant toutes les combinaisons techniquement possibles :

- il comporte une cellule élémentaire est constituée par au moins une pluralité de bascules montées en série les unes des autres, chaque bascule permettant de retarder, à chaque pas d'horloge, le signal qui lui est appliquée en entrée d'une durée qui est prédéterminée en fonction de la période d'échantillonnage du signal impulsionnel incident, et dans lequel un multiplieur est constitué par au moins une porte logique « ET ».

- le signal impulsionnel étant codé sur M bits, la ligne à retard permettant de retarder un signal impulsionnel comporte M lignes à retard élémentaires.
- le module d'analyse utilise directement le signal impulsionnel incident et/ou indirectement une consigne indicative de caractéristiques de l'impulsion du signal impulsionnel incident.
- un module de retard additionnel est prévu pour retarder le signal impulsionnel incident d'une durée correspondant à une durée d'établissement du signal binaire de détection par le module d'analyse.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés dans lesquels :

- La figure 1 est un graphique illustrant la fonction du dispositif selon l'invention ;
- La figure 2 est un schéma fonctionnel représentant un premier mode de réalisation du dispositif selon l'invention ;
- La figure 3 illustre le fonctionnement du dispositif de la figure 2 ;
- La figure 4 est un schéma fonctionnel d'une première variante d'un second mode de réalisation du dispositif selon l'invention ;
- La figure 5 est un schéma fonctionnel d'une seconde variante du second mode de réalisation du dispositif selon l'invention ;
- La figure 6 est un schéma fonctionnel d'un troisième mode de réalisation du dispositif selon l'invention ;
- La figure 7 est un schéma fonctionnel d'une première variante d'un quatrième mode de réalisation du dispositif selon l'invention ;
- La figure 8 est un schéma fonctionnel d'une second variante du quatrième mode de réalisation du dispositif selon l'invention ;
- La figure 9 est schéma bloc d'un mode de réalisation du module d'analyse du dispositif de la figure 8 ; et,
- La figure 10 est un schéma d'un mode de réalisation d'une cellule élémentaire du dispositif de la figure 8.

Premier mode de réalisation

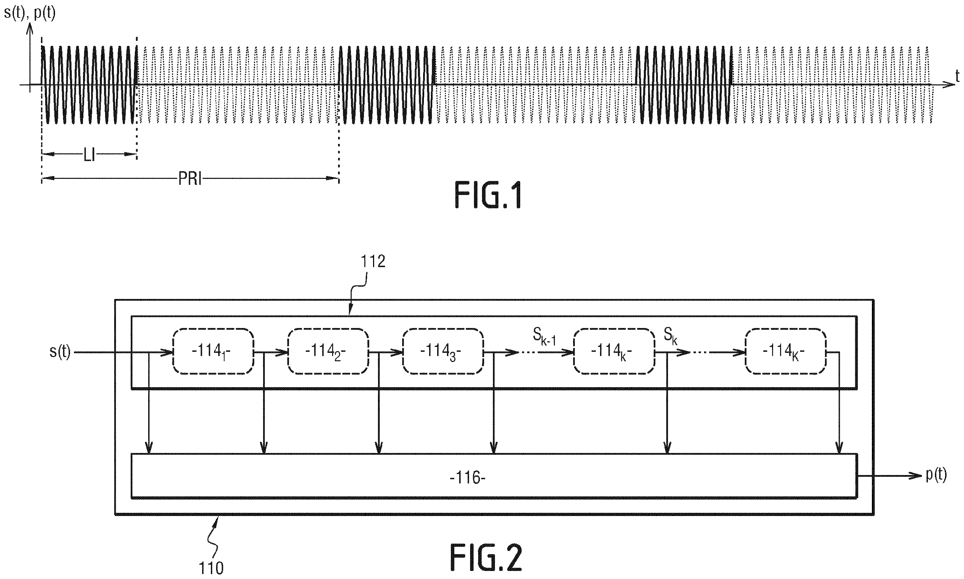

La figure 1 illustre la fonction du dispositif selon l'invention, qui est de générer à partir d'un signal impulsionnel incident s(t), appliqué en entrée du dispositif, un signal porteur p(t), délivré en sortie du dispositif.

Le signal impulsionnel incident s(t) présente une impulsion de durée limitée et récurrente dans le temps. À la figure 1, le signal impulsionnel incident s(t) est représenté en trait épais. Il possède une largeur d'impulsion LI et une période de répétition d'impulsions, ou récurrence, PRI.

Le signal porteur p(t) est représenté en trait fin et occupe la totalité de la récurrence.

Comme illustré par la figure 2, pour la réalisation de cette fonction, le dispositif 110 comporte une ligne à retard, ou LAR, 112. La LAR 112 comporte K modules de retard $114_k$, identiques entre eux et placés en série les uns à la suite des autres. À la figure 2, des modules de retard $114_1$, $114_2$, $114_3$, $114_k$ et $114_K$ sont représentés.

Chaque module de retard $114_k$ (k étant un nombre entier entre 1 et K) est propre à introduire un retard LI entre le signal $s_{k-1}$ qu'il reçoit et le signal $s_k$ qu'il délivre. Le signal $s_k$ peut donc s'écrire s(t - k. LI).

Le signal impulsionnel appliqué en entrée du premier module $114_1$ ou signal impulsionnel non retardé n'est autre, dans ce premier mode de réalisation, que le signal impulsionnel incident s(t).

Le dispositif 110 comporte également un sommateur 116 propre à sommer le signal impulsionnel s(t) non retardé et les signaux impulsionnels retardés $s_k$ délivrés en sortie de chacun des K modules $114_k$.

Le sommateur 116 délivre en sortie le signal porteur p(t).

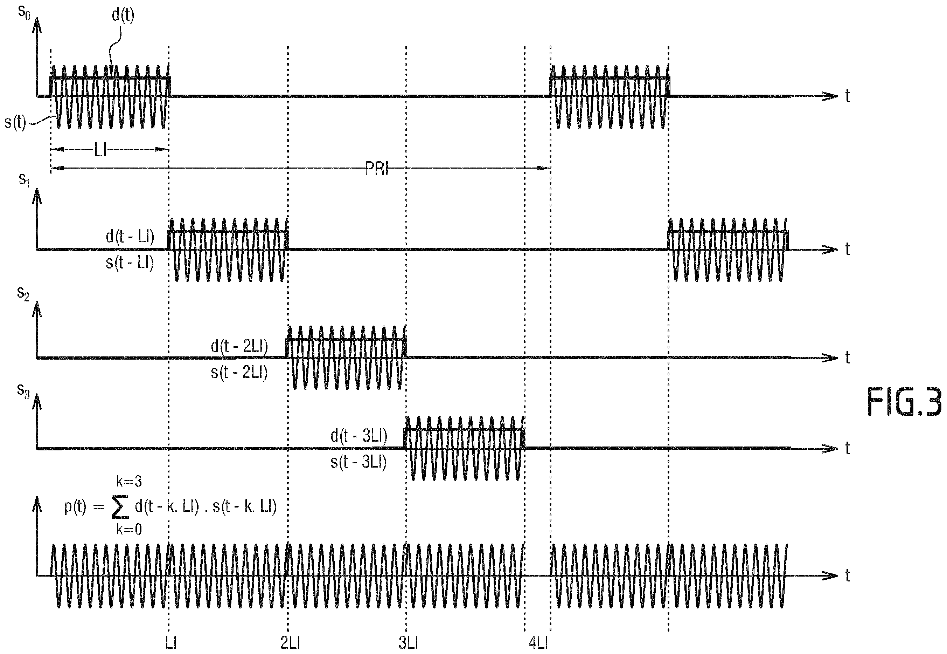

Comme illustré à la figure 3, le dispositif 110 est tel que le signal impulsionnel incident est retardé élémentairement de la durée LI, un nombre entier de fois, K, qui est égal au nombre entier de durée LI qu'il y a dans la récurrence PRI moins une unité :

$$K = \left\lfloor \frac{PRI}{LI} \right\rfloor - 1$$

où $\lfloor x \rfloor$ est la notation employée pour la partie entière de x.

Le signal porteur p(t) est obtenu en faisant la somme du signal impulsionnel incident s(t) et des différents signaux retardés de LI, 2LI, 3LI,... k.LI,... K.LI respectivement.

À la figure 3, la récurrence PRI contenant quatre fois la durée LI, le signal porteur p(t) est limité à la somme du signal impulsionnel non retardé et de trois signaux retardés respectivement de LI, 2LI et 3LI.

Ainsi de manière générale :

$$p(t) = \sum_{k=0}^{k=K} s(t - k \cdot LI)$$

avec k entier entre 0 et K, et $K = \left\lfloor \frac{PRI}{LI} \right\rfloor - 1$.

Cependant, le dispositif 110 présente des imperfections qui sont de deux types, des imperfections inhérentes au principe général de l'invention qui est de rabouter les impulsions de plusieurs signaux impulsionnels, et des imperfections qui vont être résolues dans les modes de réalisations décrits ci-après en détail.

Les imperfections inhérentes au principe général de l'invention sont les suivantes :

- L'optimisation des performances d'un radar Pulse-Doppler oblige à avoir un nombre entier de périodes de sinusoïde dans la durée LI et un nombre entier de durée LI dans la récurrence PRI. Mais, il se peut que cela ne soit pas le cas. Si le nombre de périodes de sinusoïde dans la durée LI n'est pas entier, la solution mise en œuvre par le présent dispositif ne permet pas de rabouter rigoureusement les sinusoïdes des signaux impulsionnels sommés. Cela est représenté à la figure 3, par des discontinuités entre les impulsions des signaux $s_0$ et $s_1$, des signaux $s_1$ et $s_2$, et des signaux $s_2$ et $s_3$.

- Par ailleurs, si le nombre de durée LI dans la récurrence PRI n'est pas entier, la solution mise en œuvre par le présent dispositif ne permet pas de rabouter le signal p(t) rigoureusement en phase et en temps à chaque fin de récurrence. Comme représenté également à la figure 3, il peut ainsi apparaître une absence de signal utile dans p(t) entre la fin de l'impulsion du dernier signal retardé d'une récurrence et le début de l'impulsion du signal impulsionnel non retardé de la récurrence suivante.

Cependant, il s'agit là d'imperfections mineures n'ayant que peu d'impacts sur la cohérence effective du signal porteur p(t) produit, et les applications visées peuvent parfaitement s'en accommoder.

Par ailleurs, la sommation de K signaux impulsionnels dégrade le rapport signal à bruit. C'est l'objet du second mode de réalisation de répondre à ce problème secondaire.

Il serait également souhaitable de disposer d'un dispositif programmable au sens où il serait adaptable à différents signaux impulsionnels incidents en termes de longueur d'impulsion et de période de répétition d'impulsion. C'est l'objet du troisième mode de réalisation de répondre à ce problème secondaire.

Enfin, le quatrième mode de réalisation, qui correspond au mode de réalisation préférentiel, présente à la fois un rapport à bruit non dégradé et la capacité d'être programmable.

Second mode de réalisation

L'altération du rapport signal à bruit est inhérente à la sommation des différents signaux impulsionnels par le sommateur.

En effet, le signal impulsionnel s(t) appliqué en entrée comporte du signal utile durant les impulsions et du bruit tout le temps. Il en est de même pour les signaux retardés qui ont tous s(t) pour origine.

Les différents signaux impulsionnels sommés présentent donc leurs impulsions décalées dans le temps et sans recouvrement, alors que leurs bruits, permanent sur toute la récurrence, se recouvrent complètement.

De fait, dans le signal porteur p(t) obtenu en sortie, si la puissance de signal utile est constante dans le temps (au trou près en fin de récurrence), la puissance du bruit est multipliée par le nombre de signaux impulsionnels additionnés. Ainsi, par exemple pour LI = 1$\mu$s et PRI = 20$\mu$s, on devra faire la somme de 20 signaux impulsionnels, ce qui conduira à une perte de rapport signal à bruit de 13dB. Ceci peut être préjudiciable si l'on part d'un signal impulsionnel incident s(t) présentant un rapport signal à bruit déjà peu élevé car issu d'une réception pouvant être au seuil de détection.

Le second mode de réalisation du dispositif selon l'invention a donc pour but de délivre un signal porteur présentant un rapport signal à bruit non dégradé par rapport à celui du signal impulsionnel s(t) d'origine.

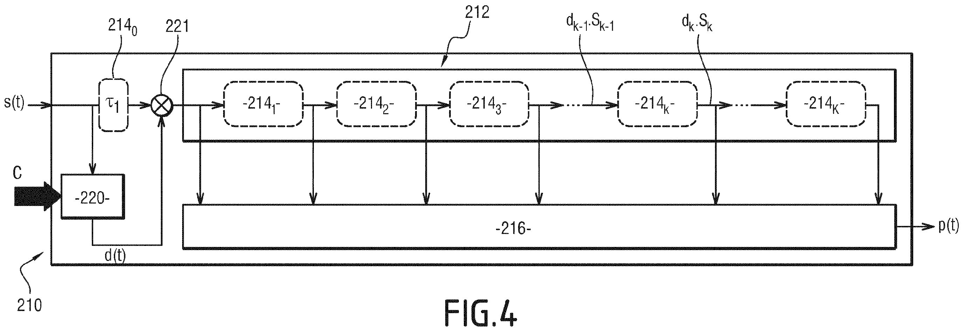

Dans une première variante de ce second mode de réalisation, représentée à la figure 4, le dispositif 210 comporte un module d'analyse 220 utilisant le signal impulsionnel incident s(t) pour déterminer en sortie un signal binaire d(t) de détection de l'impulsion du signal impulsionnel incident s(t). Le module d'analyse 220 est propre à déterminer le signal binaire directement à partir du signal impulsionnel incident appliqué en entrée du module 220 et/ou indirectement au travers d'une consigne extérieure C appliqué en entrée du module 220, comme cela sera présenté plus en détail dans la suite de la présente description.

Un tel moyen est propre à détecter le niveau en puissance du signal impulsionnel incident s(t) et à générer un signal de détection à deux états, de préférence normalisés à 0 à 1 respectivement.

Ainsi, le signal binaire d(t) vaut 1 quand la puissance instantanée du signal impulsionnel incident s(t) est supérieure ou égale à un seuil donné, et 0 sinon. Il s'agit là d'un signal binaire qui n'est donc pas affecté par un bruit.

Dans cette première variante, le dispositif 210 comporte un multiplieur 221 permettant de pondérer le signal impulsionnel incident s(t) par le signal binaire d(t) délivré en sortie du module 220. Le signal impulsionnel pondéré obtenu présente le rapport signal à bruit du signal s(t) durant l'impulsion et ne possède pas de bruit hors de l'impulsion.

Le signal impulsionnel pondéré en sortie du multiplieur 221 est appliqué en entrée d'une LAR 212.

Le signal porteur p(t) est alors la somme, réalisée par un sommateur 216, du signal impulsionnel pondéré d(t)·s(t) et des K sorties des modules de retard $214_k$. Pour le module de retard $214_k$ de rang k, ce signal impulsionnel de sortie correspond au signal impulsionnel pondéré par le signal binaire puis retardé de k·LI, soit d(t-k·LI)· s(t - k·LI).

L'expression du signal porteur p(t) est maintenant la suivante :

$$p(t) = \sum_{k=0}^{k=K} d(t - k \cdot LI) \cdot s(t - k \cdot LI)$$

avec k entier entre 0 et K, et $K = \left\lfloor \dfrac{PRI}{LI} \right\rfloor - 1.$

Le module d'analyse 220 met typiquement en œuvre un filtrage passe-bas en aval d'un redressement du signal impulsionnel incident s(t). Le signal binaire d(t) est donc produit avec un retard par rapport au signal impulsionnel incident s(t).

Il est donc avantageux de prévoir, en amont du multiplieur 221, un module de retard $214_0$ permettant d'introduire un retard de synchronisation $\tau 1$ correspondant au temps d'établissement du signal binaire d(t), de manière à ce que les signaux appliqués en entrée du multiplieur soient rigoureusement en phase.

À la figure 4 ce module de retard additionnel facultatif est représenté en traits pointillés. Le multiplieur 221 réalise alors le produit du signal impulsionnel incident retardé de $\tau 1$ et du signal binaire non retardé pour produire le signal impulsionnel non retardé appliqué en entrée de la LAR 212.

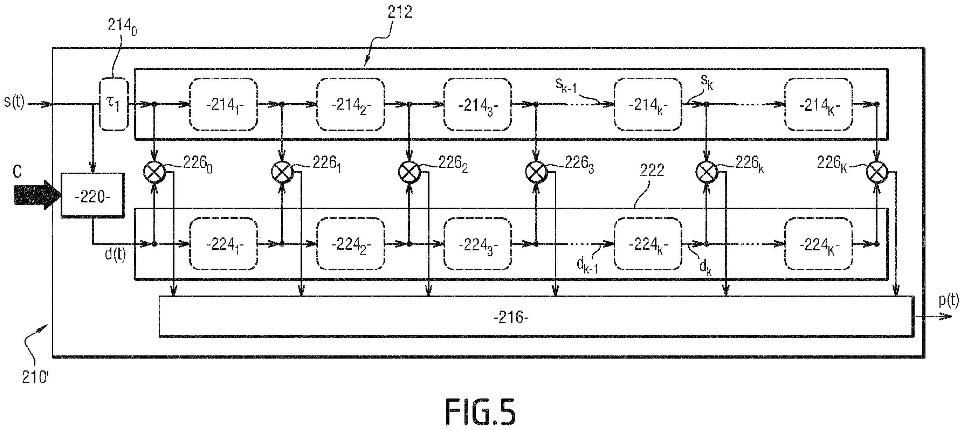

Dans une seconde variante de ce second mode de réalisation, représentée à la figure 5, le dispositif 210' comporte également un module d'analyse 220 prenant en entrée le signal impulsionnel incident s(t) et délivrant en sortie un signal binaire d(t) de détection de l'impulsion du signal impulsionnel incident s(t).

Dans cette seconde variante, le signal impulsionnel incident s(t) est appliqué en entrée d'une première ligne à retard 212, tandis que le signal binaire d(t) est appliqué en entrée d'une seconde ligne à retard 222.

La première ligne à retard 212 a été décrite ci-dessus ;

La seconde ligne à retard 222 permet de retarder le signal binaire d(t) de la même façon que le signal impulsionnel est retardé par la première ligne à retard 212.

La LAR 222 comporte donc K modules de retard $224_k$, disposés en série les uns des autres, chaque module introduisant un retard LI entre le signal binaire $d_{k-1}$ qui lui est appliqué en entrée et le signal binaire $d_k$ qu'il délivre en sortie. Le signal binaire en sortie du module 224k de rang k s'écrit donc d(t-k·LI). Le signal binaire d(t) en sortie du module d'analyse 220 est appliqué en tant que signal binaire non retardé en entrée du premier module de retard $214_1$ de la seconde LAR 222.

Sont ainsi obtenus d'une part des signaux impulsionnels retardés $s_k = s(t - k \cdot LI)$, et d'autre part des signaux binaires retardés $d_k = d(t - k \cdot LI)$, k étant un nombre entier entre 1 et K.

Le dispositif 210 comporte en outre une pluralité de composants réalisant une fonction de multiplication ou multiplieurs $226_k$, avec k variant entre 1 et K. Le multiplieur de rang k $226_k$ réalise la multiplication du signal impulsionnel retardé $s_k = s(t - k \cdot LI)$ avec le signal binaire $d_k = d(t - k \cdot LI)$ retardé d'une même quantité k. LI.

Le dispositif 210 comporte également un multiplieur de rang 0, $226_0$, réalisant la multiplication du signal impulsionnel s(t) et du signal binaire d(t).

Le signal porteur p(t) est alors la somme, réalisé par le sommateur 216, des K + 1 sorties des multiplieurs $226_k$, avec maintenant k entier entre 0 et K.

L'expression du signal porteur p(t) est alors la suivante :

$$p(t) = \sum_{k=0}^{k=K} d(t - k \cdot LI) \cdot s(t - k \cdot LI)$$

avec k entier entre 0 et K, et $K = \left\lfloor \dfrac{PRI}{LI} \right\rfloor - 1.$

Ceci est représenté à la figure 3, dans laquelle le signal binaire d(t - k · LI) permet de pondérer le signal impulsionnel s(t - k · LI) correspondant de manière à en exclure le bruit hors de l'impulsion.

Comme dans la première variante, un module de retard additionnel peut être avantageusement prévu pour synchroniser le signal impulsionnel appliqué en entrée de la première LAR et le signal binaire appliqué en entrée de la seconde LAR. Ce module $214_0$ permet d'introduire un retard correspondant au temps d'établissement du signal binaire par le module d'analyse 220.

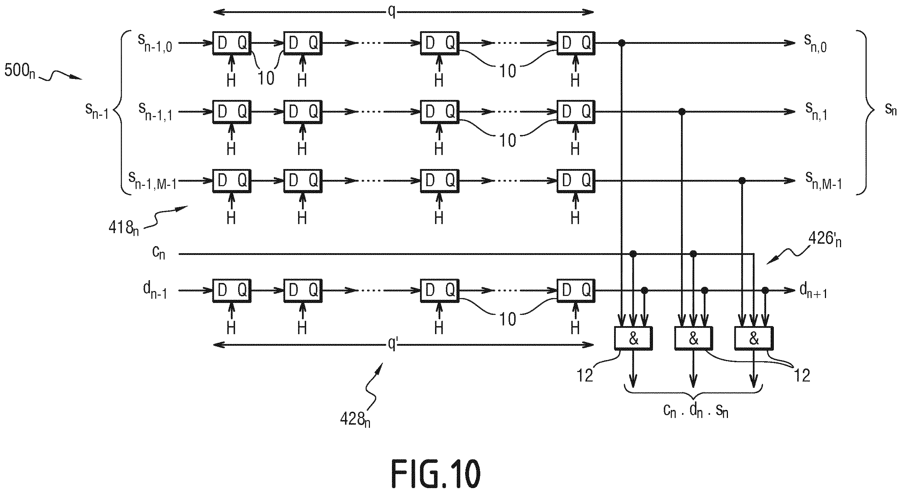

La première variante est plus simple en ce qu'elle ne comporte qu'une LAR. Cependant, comme cela sera décrit plus en détail à la figure 10, dans une réalisation numérique des lignes à retard et lorsque les signaux impulsionnels sont codés sur M bits, la première LAR est en fait composée de M lignes à retard élémentaires disposées en parallèle. En revanche, la seconde LAR, dédiée au signal binaire, ne nécessite qu'une ligne à retard élémentaire. Le gain entre les première et seconde variantes est donc d'une ligne à retard élémentaire sur une pluralité de M+1 LAR et sur K portes « ET ».

### Troisième mode de réalisation

Il est souhaitable d'avoir un dispositif qui puisse s'adapter automatiquement à n'importe quel type de formes d'onde du signal impulsionnel incident, c'est-à-dire à n'importe quel couple de valeurs LI, PRI.

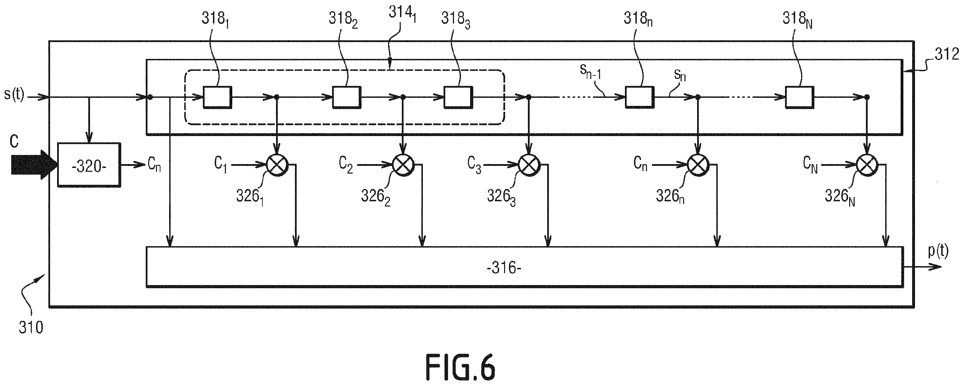

A la figure 6, est représenté un dispositif 310 selon un troisième mode de réalisation de l'invention selon lequel le dispositif est « programmable » pour permettre une adaptation automatique à n'importe quel type de formes d'onde LI, PRI entre une valeur minimale de la longueur d'impulsion $LI_{min}$ et une valeur maximale de la récurrence $PRI_{max}$.

Pour ce faire, le dispositif 310 comporte une LAR 312 segmentée en N cellules élémentaires $318_n$, avec n nombre entier entre 1 et N. Les cellules élémentaires sont placées en série. Les cellules élémentaires sont identiques entre elles. Chaque cellule introduit un retard élémentaire $\delta_\tau$ entre le signal impulsionnel qui lui est appliqué en entrée $s_{n-1}$ et le signal impulsionnel $s_n$ qu'elle délivre en sortie. Ainsi le signal $s_n$ s'écrit $s(t - n.\delta\tau)$.

Le dispositif 310 comporte également une pluralité de multiplieurs $326_n$. Le multiplieur $326_n$ de rang n est connecté entre la sortie de la cellule élémentaire $318_n$ et un sommateur 316. Le multiplieur $326_n$ de rang n pondère le signal impulsionnel $s_n$ en sortie de la cellule élémentaire $318_n$ de rang n par un coefficient $c_n$ binaire.

Le dispositif 310 comporte un module d'analyse 320 propre à déterminer la valeur de chacun des N coefficients $c_n$ en fonction du signal impulsionnel incident s(t) appliqué en entrée du dispositif 310. Un tel module met en œuvre des composants de conception conventionnelle.

La valeur du n-ième coefficient $c_n$ indique si la sortie de la n-ième cellule élémentaire $318_n$ doit être, oui ou non, appliquée au sommateur 316.

Les cellules élémentaires $318_n$ forment, en fonction de la valeur des N coefficients $c_n$ de manière à réaliser, au sein de la LAR 312, l'équivalence de K modules de retard $314_k$ (k entre 1 et K, et $K = \left\lfloor \dfrac{PRI}{LI} \right\rfloor - 1$), où chaque module introduit un retard égal à LI, les grandeurs LI et PRI étant caractéristiques du signal impulsionnel s(t) appliqué en entrée du dispositif 310. Les sorties des K modules équivalents sont sommées par le sommateur 316 pour obtenir le signal porteur p(t). On retombe ainsi sur le principe de base d'obtention du signal porteur p(t) par une synthèse.

Comme représenté à la figure 6, les trois premières cellules élémentaires $318_1$, $318_2$ et $318_3$ peuvent par exemple être associées dynamiquement pour former l'équivalent d'un module de retard $314_1$ introduisant ainsi un retard $3\,\delta\tau$ correspondant approximativement à la longueur d'impulsion détectée pour le signal impulsionnel incident s(t). Les coefficients $c_1$ et $c_2$ valent alors 0 et le coefficient $c_3$ vaut alors 1.

Plus généralement, la LAR 312 est segmentée en N cellules élémentaires introduisant un retard élémentaire de valeur $\delta\tau$.

N correspond au nombre entier de fois qu'il y a $\delta\tau$ dans $PRI_{max} - \delta\tau$, où $PRI_{max}$ est la valeur maximale de récurrence. $\delta\tau$ est la longueur d'impulsion la plus courte qu'il sera possible de traiter avec le dispositif 310. Ainsi :

$$N = \left\lfloor \frac{PRI_{max} - \delta\tau}{\delta\tau} \right\rfloor$$

où $\lfloor x \rfloor$ est la notation employée pour la partie entière de x.

Le module d'analyse 320 délivre les coefficients $c_n$ permettant de regrouper les cellules élémentaires et donc de sélectionner les sorties retardées à sommer.

La détermination des coefficients $c_n$ se fait de la façon suivante :
Les sorties de cellules utilisées pour effectuer la somme sont celles introduisant un retard multiple de LI, k. LI, avec k entre 1 et K, soit donc celles de rang $n_k$ tel que :

$$n_k = \left\lfloor \frac{k \cdot LI}{\delta\tau} \right\rfloor$$

L'écart d'indice entre deux rangs successifs utilisés est donc :

$$n_{k+1} - n_k = \left\lfloor \frac{LI}{\delta\tau} \right\rfloor$$

Le premier rang utilisé est donc :

$$n_1 = \left\lfloor \frac{LI}{\delta\tau} \right\rfloor$$

Pour une valeur de PRI donnée, l'indice k le plus élevé, correspondant au nombre K de sorties utilisées dans la somme, vaut alors :

$$K = \left\lfloor \frac{PRI}{LI} \right\rfloor - 1$$

Le dernier rang utilisé est donc :

$$n_K = \left\lfloor \frac{\left\lfloor \frac{PRI}{LI} \right\rfloor \cdot LI - LI}{\delta\tau} \right\rfloor$$

Ainsi, pour des valeurs de LI et PRI données, les coefficients $c_n$ valent 1 pour n valant $\left\lfloor \frac{k \cdot LI}{\delta\tau} \right\rfloor$ pour k entier allant de 1 à $\left\lfloor \frac{PRI}{LI} \right\rfloor - 1$ inclus, et valent 0 pour toutes les autres valeurs de n.

Le dispositif 310 délivre, en sortie du sommateur 316, le signal porteur p(t) suivant :

$$p(t) = s(t) + \sum_{n=1}^{n=N} c_n \cdot s(t - n \cdot \delta\tau)$$

et par le jeu des coefficients $c_n$, cela revient bien à obtenir le signal p(t) recherché :

$$p(t) = \sum_{k=0}^{K=\left\lfloor \frac{PRI}{LI} \right\rfloor - 1} s(t - k \cdot LI)$$

À titre d'exemple, admettons que l'on ait construit le dispositif 310 de manière à ce que : $\delta\tau = 0{,}05$ $\mu$s et $PRI_{max} = 50$ $\mu$s.

Alors la LAR 312 comprend N = 999 cellules de retard $318_n$, chacun propre à introduire une retard élémentaire

$\delta\tau$ = 0,05$\mu$s. Il existe donc 999 coefficients $c_n$ ($c_1$ à $c_{999}$).

Pour un signal impulsionnel s(t) tel que LI = 2,1$\mu$s et PRI = 10,5$\mu$s, qui est effectivement compris dans le domaine opérationnel du dispositif, on aura :

$$K = \left\lfloor \frac{PRI}{LI} \right\rfloor - 1 = \left\lfloor \frac{10,5}{2,1} \right\rfloor = 4 \; ;$$

$$n_{k+1} - n_k = \left\lfloor \frac{LI}{\delta\tau} \right\rfloor = \left\lfloor \frac{2,1}{0,05} \right\rfloor = 42 \; ;$$

$$n_1 = \left\lfloor \frac{LI}{\delta\tau} \right\rfloor = \left\lfloor \frac{2,1}{0,05} \right\rfloor = 42 \; ;$$

$$n_2 = \left\lfloor \frac{2LI}{\delta\tau} \right\rfloor = \left\lfloor \frac{4,2}{0,05} \right\rfloor = 84 \; ;$$

$$n_3 = \left\lfloor \frac{3LI}{\delta\tau} \right\rfloor = \left\lfloor \frac{6,3}{0,05} \right\rfloor = 126 \; ;$$

$$n_4 = \left\lfloor \frac{4LI}{\delta\tau} \right\rfloor = \left\lfloor \frac{8,4}{0,05} \right\rfloor = 168 \; ;$$

Donc pour ce signal impulsionnel incident s(t), $c_{42}$, $c_{84}$, $c_{126}$ et $c_{168}$ valent 1, et tous les autres coefficients $c_n$ valent 0.

Pour un autre signal s(t) tel que LI = 2,35 $\mu$s et PRI = 19 $\mu$s, qui est effectivement dans le domaine choisi, on aura :

$$K = \left\lfloor \frac{PRI}{LI} \right\rfloor - 1 = \left\lfloor \frac{19}{2,35} \right\rfloor = 7 \; ;$$

$$n_{k+1} - n_k = \left\lfloor \frac{LI}{\delta\tau} \right\rfloor = \left\lfloor \frac{2,35}{0,05} \right\rfloor = 47 \; ;$$

$$n_1 = \left\lfloor \frac{LI}{\delta\tau} \right\rfloor = \left\lfloor \frac{2,35}{0,05} \right\rfloor = 47 \; ;$$

$$n_2 = \left\lfloor \frac{2LI}{\delta\tau} \right\rfloor = \left\lfloor \frac{4,7}{0,05} \right\rfloor = 94 \; ;$$

$$n_3 = \left\lfloor \frac{3LI}{\delta\tau} \right\rfloor = \left\lfloor \frac{7,05}{0,05} \right\rfloor = 141 ;$$

$$n_4 = \left\lfloor \frac{4LI}{\delta\tau} \right\rfloor = \left\lfloor \frac{9,4}{0,05} \right\rfloor = 188 \; ;$$

$$n_5 = \left\lfloor \frac{5LI}{\delta\tau} \right\rfloor = \left\lfloor \frac{11,75}{0,05} \right\rfloor = 235 \; ;$$

$$n_6 = \left\lfloor \frac{6LI}{\delta\tau} \right\rfloor = \left\lfloor \frac{14,1}{0,05} \right\rfloor = 282 \; ;$$

$$n_7 = \left\lfloor \frac{7LI}{\delta\tau} \right\rfloor = \left\lfloor \frac{16,45}{0,05} \right\rfloor = 329 \; ;$$

Donc, pour ce signal impulsionnel incident s(t), $c_{47}$, $c_{94}$, $c_{141}$, $c_{188}$, $c_{235}$, $c_{282}$ et $c_{329}$ valent 1, et tous les autres

coefficients $c_n$ (en particulier ceux entre $c_{330}$ à $c_{999}$) valent 0.

Les valeurs des coefficients $c_n$ sont calculées à partir des valeurs LI et PRI caractéristiques du signal impulsionnel incident s(t) appliqué à l'instant courant en entrée du dispositif 310. Les valeurs des coefficients $c_n$ sont donc obtenues après un petit nombre de récurrences du signal impulsionnel incident, notamment pour pouvoir mesurer la récurrence PRI. Mais, une fois obtenus, ces coefficients $c_n$ sont stables tant que LI et PRI le sont.

Quatrième mode de réalisation

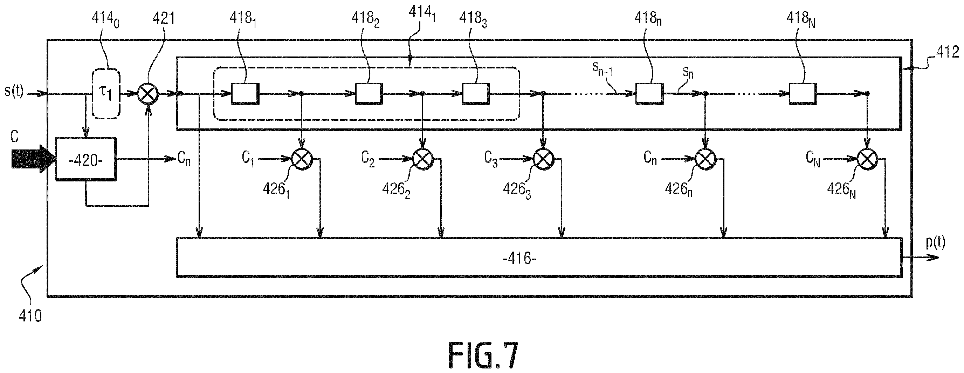

La figure 7 représente une première variante d'un quatrième mode de réalisation, qui combine, au-delà du principe général de l'invention, la première variante du second mode de réalisation et le troisième mode de réalisation.

Ainsi, le dispositif 410 comprend un module d'analyse 420 à partir du signal impulsionnel incident s(t).

Il comprend un multiplieur 421 de pondération du signal impulsionnel incident s(t) par le signal binaire de détection d(t).

Le dispositif 410 comprend une LAR 412 pour retarder le signal impulsionnel incident s(t) pondéré par un signal binaire d(t). La LAR 412 est segmentée en une pluralité de N cellules élémentaires, $418_n$ introduisant chacune un retard élémentaire $\delta\tau$.

Le dispositif 410 comporte également une pluralité de multiplieurs $426_n$. Le multiplieur $426_n$ de rang n est connecté entre la sortie de la cellule élémentaire $418_n$ et un sommateur 416. Le multiplieur $426_n$ de rang n pondère le signal impulsionnel en sortie de la cellule élémentaire $418_n$ de rang n par un coefficient binaire $c_n$.

Le module d'analyse 420 est propre à déterminer la valeur de chacun des N coefficients $c_n$ en fonction du signal impulsionnel incident s(t) appliqué en entrée du dispositif 410. Ainsi la pluralité de coefficients $c_n$ déterminés par le module d'analyse 420 à partir du signal impulsionnel incident s(t) permet de former dynamiquement l'équivalent de K modules de retard $414_k$ dans la LAR 412, chaque module introduisant un retard multiple de la longueur d'impulsion LI du signal s(t). A la figure 7, le module $414_1$ est représenté qui regroupe les trois premières cellules élémentaires $418_1$, $418_2$ et $418_3$ de la LAR 412.

Le sommateur 416 délivre en sortie le signal porteur p(t) recherché.

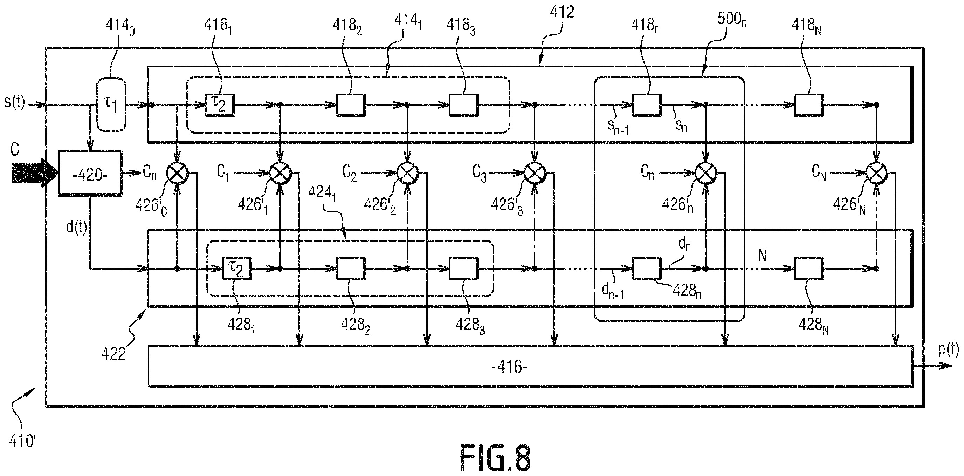

La figure 8 représente une seconde variante du quatrième mode de réalisation qui combine la seconde variante du second mode de réalisation et le troisième mode de réalisation.

Ainsi, le dispositif 410' comprend un module d'analyse 420 propre à délivrer un signal binaire d(t) de détection à partir du signal impulsionnel incident s(t).

Il comporte une première LAR 412 pour retarder le signal impulsionnel incident s(t) et une seconde LAR 422 pour retarder un signal binaire d(t).

Les première et seconde LAR 412 et 422 sont segmentées. Elles comportent une première cellule élémentaire, $418_1$ et $428_1$ respectivement, introduisant un retard élémentaire $\tau_2$ et une pluralité de N - 1 cellules élémentaires, $418_n$ et $428_n$ respectivement, introduisant chacune un retard élémentaire commun $\delta\tau$.

Le retard élémentaire $\tau_2$, correspond à la valeur minimale de la largeur d'impulsion que le dispositif 410' est capable de traiter : $LI_{min}$. Ceci permet d'avoir moins de sorties intermédiaires de LAR et d'économiser sur les composants de réalisation.

Le dispositif 410' comporte également une pluralité de multiplieurs $426'_n$. Le multiplieur $426'_n$ de rang n prend en entrée :

- la sortie de la cellule élémentaire $418_n$ de rang n de la première LAR 412 ;
- la sortie de la cellule élémentaire $428_n$ de rang n de la seconde LAR 422 ; et,
- un coefficient binaire $c_n$.

Le dispositif 410' comporte également un multiplieur $426'_0$, de rang 0 pour pondérer le signal impulsionnel incident non retardé par le signal binaire non retardé.

La sortie de chaque multiplieur $426'_n$ (n entre 0 et N) est connectée à un sommateur 416 propre à délivre le signal porteur p(t).

Le module d'analyse 420 est propre à déterminer la valeur de chacun des N coefficients $c_n$ en fonction du signal impulsionnel s(t), directement à partir du signal impulsionnel incident appliqué en entrée du module 420 et/ou indirectement au travers d'une consigne extérieure C appliqué en entrée du module 420.

Ainsi la pluralité de coefficients $c_n$ permet de former dynamiquement K modules de retard $414_k$ dans la première LAR 412 et K modules de retard $424_k$ dans la seconde LAR 422, chaque module de retard introduisant un retard LI. A la figure 8, le module $424_1$ est notamment représenté de manière illustrative. Il regroupe les trois premières cellules élémentaires $428_1$, $428_2$ et $428_3$ de la seconde LAR 422.

Plus précisément et en tenant compte du fait que dans la présente variante la première cellule élémentaire de chaque LAR introduit un retard $\tau_2 = LI_{min}$, N - 1 correspond au nombre entier de fois qu'il y a $\delta\tau$ dans $PRI_{max} - LI_{min}$, où

$PRI_{max}$ est la valeur maximale de récurrence que le dispositif 410 sera capable de traiter. Ainsi :

$$N = \left\lfloor \frac{PRI_{max} - LI_{min}}{\delta\tau} \right\rfloor + 1$$

où $\lfloor x \rfloor$ est la notation employée pour la partie entière de x.

La détermination des coefficients $c_n$ se fait comme précédemment :
Les sorties des cellules élémentaires utilisées pour effectuer la somme sont celles permettant un retard multiple de LI, soit donc celles de rang $n_k$ tel que :

$$n_k = \left\lfloor \frac{k \cdot LI - LI_{min}}{\delta\tau} \right\rfloor + 1$$

L'écart d'indice entre deux rangs successifs utilisés est donc :

$$n_{k+1} - n_k = \left\lfloor \frac{LI}{\delta\tau} \right\rfloor$$

Le premier rang utilisé est donc :

$$n_1 = \left\lfloor \frac{LI - LI_{min}}{\delta\tau} \right\rfloor + 1$$

Pour une valeur de PRI donnée, l'indice k le plus élevé, correspondant aussi au nombre de sorties utilisées, vaut alors :

$$K = \left\lfloor \frac{PRI}{LI} \right\rfloor$$

Le dernier rang utilisé est donc :

$$n_K = \left\lfloor \frac{\left\lfloor \frac{PRI}{LI} \right\rfloor \cdot LI - LI_{min}}{\delta\tau} \right\rfloor + 1$$

Ainsi, pour des valeurs de LI et PRI données, les coefficients $c_n$ valent 1 pour n valant $\left\lfloor \frac{k \cdot LI - LI_{min}}{\delta\tau} \right\rfloor + 1$ pour k entier allant de 1 à $\left\lfloor \frac{PRI}{LI} \right\rfloor$ inclus, et valent 0 pour toutes les autres valeurs de n.

Le multiplieur 426'$_n$ prend en entrée le signal impulsionnel retardé $s_n$ en sortie de la cellule élémentaire 414$_n$, le signal binaire retardé en sortie de la cellule élémentaire 428$_n$, et le coefficient $c_n$. Il délivre en sortie le signal pondéré $c_n \cdot d(t - n \cdot \delta\tau) \cdot s(t - n \cdot \delta\tau)$.

Les différents signaux pondérés sont appliqués au sommateur 416 qui délivre en sortie le signal de porteur p(t) :

$$p(t) = d(t) \cdot s(t) + \sum_{n=1}^{n=N} c_n \cdot d(t - \tau_2 - (n-1) \cdot \delta\tau) \cdot s(t - \tau_2 - (n-1) \cdot \delta\tau)$$

Par le jeu des coefficients $c_n$, cela revient bien à obtenir le signal p(t) recherché :

$$p(t) = \sum_{k=0}^{k=\left\lfloor\frac{PRI}{LI}\right\rfloor-1} d(t - k \cdot LI) \cdot s(t - k \cdot LI)$$

À titre d'exemple numérique, admettons que l'on ait choisi : $LI_{min} = 0{,}2\mu s$, $PRI_{max} = 50\mu s$ et $\delta\tau = 0{,}05\mu s$.

Alors les deux LAR comprennent chacune N = 997 cellules élémentaires, dont une première cellule élémentaire introduisant un retard $\tau_2 = 0{,}2\mu s$ suivi de N - 1 = 996 cellules élémentaires introduisant un retard $\delta\tau = 0{,}05\mu s$. Il existe donc 997 coefficients $c_n$ ($c_1$ à $c_{997}$).

Pour un signal impulsionnel s(t) tel que LI = $2{,}1\mu s$ et PRI = $10{,}5\mu s$, qui est effectivement compris dans le domaine choisi, on aura :

$$k_{max} = \left\lfloor\frac{PRI}{LI}\right\rfloor = \left\lfloor\frac{10{,}5}{2{,}1}\right\rfloor = 5 \; ;$$

$$n_{k+1} - n_k = \left\lfloor\frac{LI}{\delta\tau}\right\rfloor = \left\lfloor\frac{2{,}1}{0{,}05}\right\rfloor = 42 \; ;$$

$$n_1 = \left\lfloor\frac{LI-LI_{min}}{\delta\tau}\right\rfloor + 1 = \left\lfloor\frac{2{,}1-0{,}2}{0{,}05}\right\rfloor + 1 = 39 \; ;$$

$$n_2 = \left\lfloor\frac{2LI-LI_{min}}{\delta\tau}\right\rfloor + 1 = \left\lfloor\frac{4{,}2-0{,}2}{0{,}05}\right\rfloor + 1 = 81 \; ;$$

$$n_3 = \left\lfloor\frac{3LI-LI_{min}}{\delta\tau}\right\rfloor + 1 = \left\lfloor\frac{6{,}3-0{,}2}{0{,}05}\right\rfloor + 1 = 123 \; ;$$

$$n_4 = \left\lfloor\frac{4LI-LI_{min}}{\delta\tau}\right\rfloor + 1 = \left\lfloor\frac{8{,}4-0{,}2}{0{,}05}\right\rfloor + 1 = 165 \; ;$$

$$n_5 = \left\lfloor\frac{5LI-LI_{min}}{\delta\tau}\right\rfloor + 1 = \left\lfloor\frac{10{,}5-0{,}2}{0{,}05}\right\rfloor + 1 = 207 \; ;$$

Donc pour ce signal s(t), $C_{39}$, $c_{81}$, $c_{123}$, $c_{165}$ et $c_{207}$ valent 1, et tous les autres coefficient $c_n$ (c'est-à-dire $c_1$ à $c_{38}$, $c_{40}$ à $c_{80}$, $c_{82}$ à $c_{122}$, $c_{124}$ à $c_{164}$, $c_{166}$ à $c_{206}$, et $c_{208}$ à $c_{997}$) valent 0.

Pour un autre signal s(t) tel que LI = $2{,}35\mu s$ et PRI = $19\mu s$, qui est effectivement dans le domaine choisi, on aura :

$$k_{max} = \left\lfloor\frac{PRI}{LI}\right\rfloor = \left\lfloor\frac{19}{2{,}35}\right\rfloor = 8 \; ;$$

$$n_{k+1} - n_k = \left\lfloor\frac{LI}{\delta\tau}\right\rfloor = \left\lfloor\frac{2{,}35}{0{,}05}\right\rfloor = 47 \; ;$$

$$n_1 = \left\lfloor\frac{LI-LI_{min}}{\delta\tau}\right\rfloor + 1 = \left\lfloor\frac{2{,}35-0{,}2}{0{,}05}\right\rfloor + 1 = 44 \; ;$$

$$n_2 = \left\lfloor\frac{2LI-LI_{min}}{\delta\tau}\right\rfloor + 1 = \left\lfloor\frac{4{,}7-0{,}2}{0{,}05}\right\rfloor + 1 = 91 \; ;$$

$$n_3 = \left\lfloor\frac{3LI-LI_{min}}{\delta\tau}\right\rfloor + 1 = \left\lfloor\frac{7{,}05-0{,}2}{0{,}05}\right\rfloor + 1 = 138 \; ;$$

$$n_4 = \left\lfloor \frac{4LI - LI_{min}}{\delta\tau} \right\rfloor + 1 = \left\lfloor \frac{9,4 - 0,2}{0,05} \right\rfloor + 1 = 185 \ ;$$

$$n_5 = \left\lfloor \frac{5LI - LI_{min}}{\delta\tau} \right\rfloor + 1 = \left\lfloor \frac{11,75 - 0,2}{0,05} \right\rfloor + 1 = 232 \ ;$$

$$n_6 = \left\lfloor \frac{6LI - LI_{min}}{\delta\tau} \right\rfloor + 1 = \left\lfloor \frac{14,1 - 0,2}{0,05} \right\rfloor + 1 = 279 \ ;$$

$$n_7 = \left\lfloor \frac{7LI - LI_{min}}{\delta\tau} \right\rfloor + 1 = \left\lfloor \frac{16,45 - 0,2}{0,05} \right\rfloor + 1 = 326 \ ;$$

$$n_8 = \left\lfloor \frac{8LI - LI_{min}}{\delta\tau} \right\rfloor + 1 = \left\lfloor \frac{18,8 - 0,2}{0,05} \right\rfloor + 1 = 373 \ ;$$

Donc, pour ce signal s(t), $c_{44}$, $c_{91}$, $c_{138}$, $c_{185}$ $c_{39}$, $c_{232}$, $c_{279}$, $c_{326}$ et $c_{373}$ valent 1, et tous les autres coefficients $c_n$ (c'est-à-dire $c_1$ à $c_{43}$, $c_{45}$ à $c_{90}$, $c_{92}$ à $c_{137}$, $c_{139}$ à $c_{184}$, $c_{186}$ à $c_{231}$, $c_{233}$ à $c_{278}$, $c_{280}$ à $c_{325}$, $c_{327}$ à $c_{372}$, et $c_{373}$ à $c_{997}$) valent 0.

De manière avantageuse, il convient de retarder correctement le signal s(t) pour tenir compte du temps nécessaire à l'établissement du signal binaire d(t) par le module d'analyse. Pour ce faire, un module de retard $414_0$ introduisant un retard $\tau_1$ est avantageusement prévu soit en amont du multiplieur 421 dans la première variante soit en entrée de la première LAR 412 dans la seconde variante.

Cependant, on notera que, pour des applications pour lesquelles le temps de retard complet doit être minimisé, on peut revenir à un dispositif ne présentant pas ce module de retard de rang 0, la contrepartie étant alors un défaut transitoire acceptable du fonctionnement au début.

Module d'analyse

Si le signal appliqué en entrée du dispositif ne comporte qu'un unique signal impulsionnel incident, alors le module d'analyse pour élaborer d(t) peut par exemple comporter un sous-module de détection quadratique suivi d'un sous-module de filtrage passe-bas puis d'un comparateur avec un seuil pour obtenir deux états non bruités.

Mais le signal appliqué en entrée du dispositif comporte le plus souvent plusieurs signaux impulsionnels incidents s(t) superposés. Dans ce cas, le signal d(t) élaboré par le module d'analyse doit pouvoir ne correspondre qu'à l'un des signaux impulsionnels incidents considéré comme le signal impulsionnel incident d'intérêt, dans le but de générer un signal porteur cohérent avec ce signal impulsionnel incident d'intérêt et sans défaut de cohérence dû à la présence de l'autre ou des autres signaux impulsionnels incidents.

Le module d'analyse reçoit alors une consigne C extérieure au dispositif, lui indiquant les caractéristiques du signal impulsionnel incident d'intérêt pour l'aider à élaborer le signal binaire d(t) et/ou les coefficients $c_n$. Dans les figures, ceci est représenté par une flèche vers le module d'analyse.

La consigne C comprend par exemple des grandeurs mesurées définissant le signal d'intérêt ainsi que des tolérances permettant de définir des plages de valeurs admissibles, ces tolérances tenant compte des dispersions effectives des mesures faites par ailleurs et des mesures à faire par le module d'analyse. La consigne C comprend par exemple :

- La fréquence d'émission $f_x$ et sa tolérance associée $\pm\Delta f_x$ ;
- La largeur d'impulsion $LI_x$ et sa tolérance associée $\pm\Delta LI_x$ ;
- La modulation intra-impulsion (éventuellement) $IMOP_x$ et sa tolérance associée $\pm AIMOP_x$ ;
- La direction d'arrivée (éventuellement) $\theta_x$ et sa tolérance associée $\theta_x \pm \Delta\theta_x$ ;
- La polarisation (éventuellement) $Pol_x$ ;
- La période de répétition des impulsions $PRI_x$.

Il est à noter que les applications envisagées pour le dispositif selon l'invention sont en fait généralement pilotées. Le dispositif est alors intégré au sein d'un système plus complexe propre à déterminer le signal impulsionnel incident d'intérêt et à en informer le dispositif de génération d'un signal porteur selon l'invention.

Dans ce cas, le module d'analyse élabore le signal binaire d(t) de manière sélective en analysant les impulsions composant chaque signal impulsionnel incident. Des méthodes classiques de l'état de l'art sont mises en œuvre. Par analyse de chaque signal impulsionnel, il faut comprendre au moins la mesure des caractéristiques suivantes : la largeur de l'impulsion (LI), la date d'arrivée de cette impulsion (ou TOA pour « Time Of Arrivai », qui est en fait la date du front avant de l'impulsion) et la fréquence porteuse (f). La fréquence porteuse est mesurée, par exemple, à l'aide d'une fonction de mesure de fréquence instantanée de type IFM (selon l'abréviation anglaise « Instantaneous Frequency Measurement »). Pour des applications non contraintes en complexité matérielle, on peut imaginer que cette analyse ajoute des caractéristiques de direction d'arrivée, de polarisation et de modulation intra-impulsion. À l'instar de la fréquence porteuse, ces caractéristiques sont mesurées par des dispositifs et méthodes connues de l'homme du métier.

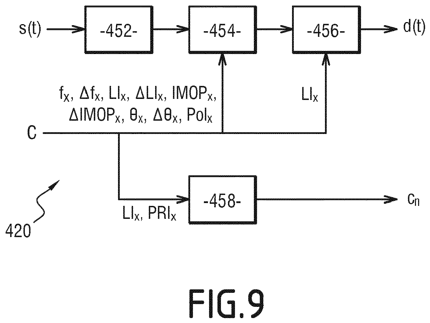

La figure 9 est une représentation fonctionnelle d'une structure possible du module d'analyse. Dans cette figure est plus particulièrement représenté le module d'analyse 420.

Il comporte :

- un sous-module de mesure 452 propre à mesurer des caractéristiques du signal impulsionnel incident ;
- un sous-module de comparaison 454 propre à comparer des mesures délivrées par le sous module 452 à des plages permises par la consigne C ;
- un sous-module d'élaboration 456 propre à élaborer le signal binaire à partir des sorties du sous-module de comparaison 454 et de la consigne C ; et,
- un sous module de calcul 458 propre à calculer les coefficients $c_n$.

Le sous-module 452 a pour fonction de mesurer les caractéristiques de chaque impulsion présente dans le signal appliqué en entrée du dispositif au fur et à mesure de leur arrivée (cf. état de l'art dans les détecteurs de radars). Ces caractéristiques sont au moins la fréquence d'émission, la largeur d'impulsion et, éventuellement (selon les applications) la modulation intra-impulsion, la direction d'arrivée et la polarisation (de l'onde incidente correspondant au signal).

Le sous-module 454 a pour fonction de comparer l'ensemble des caractéristiques de l'impulsion mesurées aux plages de mesures tolérées. Une impulsion donnée est retenue seulement si toutes les caractéristiques mesurées sont comprises dans les plages tolérées associées, sinon l'impulsion est rejetée. Pour une quelconque caractéristique de consigne $Y_x$, la plage de mesures tolérées est définie par l'intervalle $[Y_x - \Delta Y_x \; Y_x + \Delta Y_x]$ ;

Le sous-module 455 a pour fonction d'élaborer le signal binaire d(t) uniquement sur le signal d'intérêt correspondant à la consigne. Pour cela, chaque impulsion retenue par le sous-module 454 engendre la création d'une impulsion de largeur $LI_x$. Il est important de noter que, par principe, le signal binaire d(t) ainsi élaboré est en retard, par rapport à s(t), d'un temps égal à $LI_x + \Delta LI_x$ augmenté des temps d'établissement des données de sortie des différents sous-modules.

Les valeurs $LI_x$ et $PRI_x$ sont utilisées directement pour calculer les coefficients $c_n$ de programmation par le sous-module 458 selon les formules indiquées ci-dessus. Ce calcul met un certain temps, toutefois relativement court à l'échelle de temps des impulsions. Ces coefficients restent fixes : ils ne sont pas recalculés tant que $LI_x$ et $PRI_x$ sont fixes.

Implémentation en numérique

Dans une application concrète, la ou chaque LAR du dispositif selon l'invention peut être réalisée en analogique comme en numérique.

Toutefois, la réalisation en numérique s'avère particulièrement intéressante. En effet, les opérations de multiplications par 0 ou 1 et les additions sont faciles à faire, en particulier avec des circuits numériques programmables du type FPGA (pour « Field Programmable Gate Array »).

À titre d'exemple, la figure 10 représente une réalisation numérique possible d'une portion élémentaire $500_n$ du dispositif 410' de la figure 8 correspondant, pour le rang n, avec n entre 1 et N, à une cellule élémentaire $418_n$ de la première LAR, une cellule élémentaire $428_n$ de la seconde LAR et du multiplieur $426'_n$ associant les sorties de ces deux cellules élémentaires de même rang.

Si le signal impulsionnel incident s(t) est numérisé sur M bits, la première LAR 412 comporte en fait M LAR numériques élémentaires, une par bit, en parallèle.

Chacune de ces LAR numériques élémentaires est constituée de q bascules 10 montées en série, chaque bascule 10 retardant le signal appliqué sur son entrée, à chaque coup d'horloge H, d'un retard $T_{éch}$. $T_{éch}$ est la période de l'horloge H, mais aussi la période d'échantillonnage temporel du signal impulsionnel incident s(t). Le nombre q de bascules est choisi pour qu'une cellule élémentaire d'une LAR numérique élémentaire introduise un retard total élémentaire $d\tau = q \cdot T_{éch}$ entre le signal appliquée en entrée $s_{n-1,m}$ et le signal délivré en sortie $s_{n,m}$.

Le signal de détection étant binaire, une seule LAR numérique élémentaire compose la seconde LAR 422. Elle est constituée d'un nombre q de bascules 10 qui est identique à celui de la cellule élémentaire de même rang de la première LAR 412 de façon à introduire un retard élémentaire identique.

Les M portes logiques « ET » 12, qui forment le multiplieur $426'_n$ réalisent respectivement l'opération élémentaire : $c_n \cdot d_n \cdot s_{n,m}$, avec m entre 0 et M-1.

Pour des raisons de performances des circuits numériques disponibles, il est possible que la fréquence de l'horloge H, 1/T, doive être inférieure à la fréquence d'échantillonnage du signal $1/T_{éch}$, alors il faudra procéder à des décompositions temporelles des signaux à retarder en sous-séries $\{x_{n+i}\}$ avec i = T/T$_{éch}$ entier, puis à des recompositions. Ces opérations connues sont respectivement dénommées Démultiplexage et Multiplexage.

De plus, le signal impulsionnel incident s(t) ayant été numérisé auparavant par une conversion analogique-numérique appropriée, le module d'analyse peut être également complètement réalisé en numérique avec les mêmes circuits élémentaires que ceux réalisant les LAR, les multiplications et les additions, y compris les parties mesurant la fréquence de porteuse et l'éventuelle mesure de modulation intra-impulsion.

La réalisation en numérique permet donc une très grande intégration du dispositif et donc une utilisation aisée dans des applications très contraintes en dimensions et masse, telles que les applications consommables en guerre électronique.

De plus, la mémoire numérique (bascules) utilisée est un composant bon marché. La mémoire nécessite malgré tout d'être gérée, mais c'est une gestion strictement dédiée à la fonction, donc simple à réaliser.

**Revendications**

1. Dispositif (210) de génération d'un signal porteur (p(t)) à partir d'un signal impulsionnel incident (s(t)), ledit signal impulsionnel incident comportant des impulsions périodiques **caractérisées par** une largeur d'impulsion (LI) et une période de répétition (PRI), le dispositif comportant :

   - un module d'analyse (220) propre à générer un signal binaire (d(t)) de détection de l'impulsion dans le signal impulsionnel incident (s(t)), ledit signal impulsionnel incident (s(t)) étant appliqué en entrée dudit module d'analyse ;
   - un multiplieur (221) propre à pondérer le signal impulsionnel incident (s(t)) par le signal binaire (d(t)) pour obtenir un signal impulsionnel pondéré ne possédant plus de bruit hors impulsion ;
   - une ligne à retard (212) comportant K modules de retard (214$_k$) disposés en série les uns des autres, chaque module de retard étant propre à retarder un signal impulsionnel d'entrée, appliqué en entrée dudit module de retard, pour délivrer un signal impulsionnel de sortie correspondant au signal impulsionnel d'entrée retardé d'une largeur d'impulsion, le signal impulsionnel d'entrée appliqué en entrée du premier module de retard de la ligne à retard correspondant au signal impulsionnel pondéré délivré en sortie du multiplieur, et le nombre K de modules de retard étant égal à la partie entière de la période de répétition divisée par la largeur d'impulsion, diminuée d'une unité ; et,
   - un sommateur (216) propre à sommer le signal impulsionnel pondéré en sortie du multiplieur et les K signaux impulsionnels de sortie des K modules de retard de la ligne de retard pour obtenir le signal porteur (p(t)).

2. Dispositif (410) selon la revendication 1, dans lequel la ligne à retard (412) comporte :

   - une pluralité de N cellules élémentaires (418$_n$) montées en série les unes des autres, chaque cellule élémentaire étant propre à introduire un retard élémentaire ($\tau_2$;$\delta\tau$) dans un signal d'entrée appliqué en entrée de ladite cellule élémentaire pour délivrer en sortie un signal de sortie retardé ; et,
   - une pluralité de N multiplieurs (426$_n$), le multiplieur de rang n, n étant un nombre entier entre 1 et N, permettant de multiplier le signal de sortie de la cellule élémentaire de rang n de la ligne à retard (412) par un coefficient (c$_n$) d'une pluralité de N coefficients, chaque coefficient étant déterminé par le module d'analyse (420) à partir du signal impulsionnel incident (s(t)) de manière à regrouper les cellules élémentaires pour former lesdits K modules de retard (414$_k$) de la ligne de retard.

3. Dispositif (210') de génération d'un signal porteur (p(t)) à partir d'un signal impulsionnel incident (s(t)), ledit signal impulsionnel incident comportant des impulsions périodiques **caractérisées par** une largeur d'impulsion (LI) et une période de répétition (PRI), le dispositif comportant :

   - un module d'analyse (220) propre à générer un signal binaire (d(t)) de détection de l'impulsion dans le signal impulsionnel incident (s(t)), ledit signal impulsionnel incident étant appliqué en entrée dudit module d'analyse ;
   - une première ligne à retard (212) dédiée au signal impulsionnel incident (s(t)) et comportant K modules de retard (214$_k$) disposés en série les uns des autres, chaque module de retard étant propre à retarder un signal impulsionnel d'entrée, appliqué en entrée dudit module de retard, pour délivrer un signal impulsionnel de sortie, en sortie dudit module de retard, correspondant au signal impulsionnel d'entrée retardé d'une largeur d'impulsion, le signal impulsionnel d'entrée appliqué en entrée du premier module de retard de la première ligne de retard correspondant au signal impulsionnel incident (s(t)), et le nombre K de modules de retard étant égal à la partie entière de la période de répétition divisée par la largeur d'impulsion, diminuée d'une unité ;

- une seconde ligne de retard (222) dédiée au signal binaire (d(t)) et comportant K modules de retard ($224_k$) disposés en série les uns des autres, chaque module de retard étant propre à retarder un signal binaire d'entrée, appliqué en entrée dudit module de retard, pour délivrer un signal binaire de sortie, en sortie dudit module de retard, correspondant au signal binaire d'entrée retardé de la largeur d'impulsion, le signal binaire d'entrée appliqué en entrée du premier module de retard de la seconde ligne de retard correspondant au signal binaire délivré par le module d'analyse ;

- un multiplieur de rang 0 propre à pondérer le signal impulsionnel incident (s(t)) par le signal binaire (d(t)) pour obtenir un signal impulsionnel pondéré n'ayant pas de bruit hors impulsion ;

- une pluralité de multiplieurs ($226_k$), le multiplieur de rang k, k étant un nombre entier entre 1 et K, propre à pondérer le signal impulsionnel de sortie ($s_k$) délivré en sortie du module de retard ($214_k$) de rang k de la première ligne de retard par le signal binaire de sortie ($d_k$) délivré en sortie du module de retard ($224_k$) de rang k de la seconde ligne de retard, pour obtenir des signaux impulsionnels pondérés retardés n'ayant pas de bruit hors impulsion ; et,

- un sommateur (216) propre à sommer le signal impulsionnel pondéré en sortie du multiplieur de rang 0 et les K signaux impulsionnel pondérés retardés en sortie des K multiplieurs de rang k pour obtenir le signal porteur continu.

4. Dispositif (410') selon la revendication 3, dans lequel chaque ligne à retard (412 ; 422) comporte :

- une pluralité de N cellules élémentaires ($418_n$ ; $428_n$) montées en série les unes des autres, chaque cellule élémentaire étant propre à introduire un retard élémentaire ($\tau_2 ; \delta\tau$) dans un signal d'entrée, appliqué en entrée de ladite cellule élémentaire, pour délivrer un signal de sortie, en sortie de ladite cellule élémentaire, retardé ; et,

- une pluralité de N multiplieurs ($426_n$), le multiplieur de rang n, n étant un nombre entier entre 1 et N, permettant de multiplier le signal impulsionnel de sortie ($s_n$) de la cellule élémentaire de rang n ($418_n$) de la première ligne de retard (412) par le signal binaire de sortie ($d_n$) de la cellule élémentaire de rang n ($428_n$) de la seconde ligne de retard (422) et par un coefficient ($c_n$) d'une pluralité de N coefficients, chaque coefficient ($c_n$) étant déterminé par le module d'analyse (420) à partir du signal impulsionnel incident (s(t)) de manière à former lesdits K modules de retard ($414_k$ ; $424_k$) à partir des cellules élémentaires des lignes de retard.

5. Dispositif (410') selon la revendication 2 ou la revendication 4, dans lequel une cellule élémentaire ($418_n$ ; $428_n$) est constituée par au moins une pluralité de bascules (10) montées en série les unes des autres, chaque bascule permettant de retarder, à chaque pas d'horloge, le signal qui lui est appliquée en entrée d'une durée qui est prédéterminée en fonction de la période d'échantillonnage ($T_{éch}$) du signal impulsionnel incident (s(t)), et dans lequel un multiplieur ($426_n$) est constitué par au moins une porte logique « ET ».

6. Dispositif selon la revendication 5, dans lequel le signal impulsionnel (s(t)) étant codé sur M bits, la ligne à retard permettant de retarder un signal impulsionnel comporte M lignes à retard élémentaires.

7. Dispositif selon l'une quelconque des revendications 1 à 6, dans lequel le module d'analyse (220, 420) utilise directement le signal impulsionnel incident et/ou indirectement une consigne (C) indicative de caractéristiques de l'impulsion du signal impulsionnel incident (s(t)).

8. Dispositif (220) selon l'une quelconque des revendications 1 à 7, dans lequel un module de retard additionnel ($214_0$) est prévu pour retarder le signal impulsionnel incident (s(t)) d'une durée correspondant à une durée d'établissement du signal binaire (d(t)) de détection par le module d'analyse (220).

**Patentansprüche**

1. Vorrichtung (210) zur Erzeugung eines Trägersignals (p(t)) aus einem eingehenden Impulssignal (s(t)), wobei das eingehende Impulssignal periodische Impulse aufweist, welche durch eine Impulsdauer (LI) und durch eine Wiederholungsperiode (PRI) charakterisiert sind, wobei die Vorrichtung aufweist:

- ein Analysemodul (220), welches dazu geeignet ist, ein Binärsignal (d(t)) zur Detektion des Impulses in dem eingehenden Impulssignal (s(t)) zu erzeugen, wobei das eingehende Impulssignal (s(t)) an den Eingang das Analysemoduls angelegt ist,
- einen Multiplizierer (221), welcher dazu geeignet ist, das eingehende Impulssignal (s(t)) mit dem Binärsignal (d(t)) zu gewichten, um ein gewichtetes Impulssignal zu erlangen, welches kein Rauschen außerhalb eines Impulses mehr aufweist,

- eine Verzögerungsreihe (212), welche K Verzögerungsmodule ($214_k$) aufweist, die in Reihe hintereinander angeordnet sind, wobei jedes Verzögerungsmodul dazu geeignet ist, ein Eingangsimpulssignal, welches am Eingang des Verzögerungsmoduls angelegt ist, zu verzögern, um ein Ausgangsimpulssignal zu liefern, welches dem um eine Impulsdauer verzögerten Eingangsimpulssignal entspricht, wobei das am Eingang des ersten Verzögerungsmodul der Verzögerungsreihe angelegte Eingangsimpulssignal dem gewichteten Impulssignal, welches vom Ausgang des Multiplizierers geliefert wird, entspricht, und wobei die Zahl K an Verzögerungsmodulen gleich dem ganzzahligen Teil der durch die Impulsdauer geteilten Wiederholungsperiode minus eine Einheit ist, und

- einen Summierer (216), welcher dazu geeignet ist, das gewichtete Impulssignal am Ausgang des Multiplizierers und die K Impulssignale des Ausgangs der K Verzögerungsmodule der Verzögerungsreihe zu summieren, um das Trägersignal (p(t)) zu erlangen.

2. Vorrichtung (410) gemäß dem Anspruch 1, wobei die Verzögerungsreihe (412) aufweist:

- eine Mehrzahl von N Elementarzellen ($418_n$), welche in Reihe hintereinander angebracht sind, wobei jede Elementarzelle dazu geeignet ist, eine Elementarverzögerung ($\tau_2$, $\delta\tau$) in ein Eingangssignal, welches an den Eingang der Elementarzelle angelegt ist, einzubringen, um am Ausgang ein verzögertes Ausgangssignal zu liefern, und

- eine Mehrzahl von N Multiplizierer ($426_n$), wobei der Multiplizierer mit Rang n, wobei n eine ganze Zahl zwischen 1 und N ist, es erlaubt, das Ausgangssignal der Elementarzelle mit Rang n der Verzögerungsreihe (412) mit einem Koeffizienten ($c_n$) aus einer Mehrzahl von N Koeffizienten zu multiplizieren, wobei jeder Koeffizient durch das Analysemodul (420) aus dem eingehenden Impulssignal (s(t)) derart ermittelt wird, dass die Elementarzellen umgruppiert werden, um die K Verzögerungsmodule ($414_k$) der Verzögerungsreihe zu bilden.

3. Vorrichtung (210') zur Erzeugung eines Trägersignals (p(t)) aus einem eingehenden Impulssignal (s(t)), wobei das eingehende Impulssignal aufweist periodische Impulse, welche durch eine Impulsdauer (LI) und durch eine Wiederholungsperiode (PRI) charakterisiert sind, wobei die Vorrichtung aufweist:

- ein Analysemodul (220), welches dazu geeignet ist, ein Binärsignal (d(t)) zur Detektion des Impulses in dem eingehenden Impulssignal (s(t)) zu erzeugen, wobei das eingehende Impulssignal (s(t)) an den Eingang das Analysemoduls angelegt ist,

- eine erste Verzögerungsreihe (212), welche dem eingehenden Impulssignal (s(t)) gewidmet ist und K Verzögerungsmodule ($214_k$) aufweist, die in Reihe hintereinander angeordnet sind, wobei jedes Verzögerungsmodul dazu geeignet ist, ein Eingangsimpulssignal, welches am Eingang des Verzögerungsmoduls angelegt ist, zu verzögern, um ein Ausgangsimpulssignal am Ausgang des Verzögerungsmoduls zu liefern, welches dem um eine Impulsdauer verzögerten Eingangsimpulssignal entspricht, wobei das am Eingang des ersten Verzögerungsmodul der ersten Verzögerungsreihe angelegte Eingangsimpulssignal dem eingehenden Impulssignal (s(t)) entspricht, und wobei die Zahl K an Verzögerungsmodulen gleich dem ganzzahligen Teil der durch die Impulsdauer geteilten Wiederholungsperiode minus eine Einheit ist, und

- eine zweite Verzögerungsreihe (222), welche dem Binärsignal (d(t)) gewidmet ist und K Verzögerungsmodule ($224_k$) aufweist, die in Reihe hintereinander angeordnet sind, wobei jedes Verzögerungsmodul dazu geeignet ist, ein Eingangsbinärsignal, welches am Eingang des Verzögerungsmoduls angelegt ist, zu verzögern, um ein Ausgangsbinärsignal am Ausgang des Verzögerungsmoduls zu liefern, welches dem um die Impulsdauer verzögerten Eingangsbinärsignal entspricht, wobei das am Eingang des ersten Verzögerungsmoduls der zweiten Verzögerungsreihe (222) angelegte Eingangsbinärsignal dem durch das Analysemodul gelieferten Binärsignal entspricht,

- einen Multiplizierer mit Rang 0, welcher dazu geeignet ist, das eingehende Impulssignal (s(t)) mit dem Binärsignal (d(t)) zu gewichten, um ein gewichtetes Impulssignal zu erlangen, welches kein Rauschen außerhalb eines Impulses aufweist,

- eine Mehrzahl von Multiplizierern ($226_k$), wobei der Multiplizierer mit Rang k, wobei k eine ganze Zahle zwischen 1 und K ist, dazu geeignet ist, das Ausgangsimpulssignal ($s_k$), welches am Ausgang des Verzögerungsmoduls ($214_k$) mit Rang k der ersten Verzögerungsreihe geliefert wird, mit dem Ausgangsbinärsignal ($d_k$), welches am Ausgang des Verzögerungsmoduls ($224_k$) mit Rang k der zweiten Verzögerungsreihe geliefert wird, zu gewichten, um gewichtete verzögerte Impulssignale zu erlangen, welche keine Rauschen außerhalb des Impulses aufweisen, und

- einen Summierer (216), welcher dazu geeignet ist, das gewichtete Impulssignal am Ausgang des Multiplizierers mit Rang 0 und die gewichteten verzögerten K Impulssignale am Ausgang der K Multiplizierer mit Rang k zu summieren, um das kontinuierliche Trägersignal zu erlangen.

4. Vorrichtung (410) gemäß dem Anspruch 3, wobei jede Verzögerungsreihe (412; 422) aufweist:

- eine Mehrzahl von N Elementarzellen ($418_n$; $428_n$), welche in Reihe hintereinander angebracht sind, wobei jede Elementarzelle dazu geeignet ist, eine Elementarverzögerung ($\tau_2$, $\delta\tau$) in ein Eingangssignal, welches an den Eingang der Elementarzelle angelegt ist, einzubringen, um am Ausgang der Elementarzelle ein verzögertes Ausgangssignal zu liefern, und
- eine Mehrzahl von N Multiplizierer ($426_n$), wobei der Multiplizierer mit Rang n, wobei n eine ganze Zahl zwischen 1 und N ist, es erlaubt, das Ausgangsimpulssignal ($s_n$) der Elementarzelle mit Rang n ($418_n$) der ersten Verzögerungsreihe (412) mit dem Ausgangsbinärsignal ($d_n$) der Elementarzelle mit Rang n ($428_n$) der zweiten Verzögerungsreihe (422) und mit einem Koeffizienten ($c_n$) aus einer Mehrzahl von N Koeffizienten zu multiplizieren, wobei jeder Koeffizient ($c_n$) durch das Analysemodul (420) aus dem eingehenden Impulssignal (s(t)) derart ermittelt wird, dass die K Verzögerungsmodule ($414_k$; $424_k$) aus den Elementarzellen der Verzögerungsreihen gebildet werden.

5. Vorrichtung (410) gemäß dem Anspruch 2 oder dem Anspruch 4, wobei eine Elementarzelle ($418_n$; $428_n$) durch mindestens eine Mehrzahl von Kippstufen (10) gebildet ist, welche in Reihe hintereinander angebracht sind, wobei jede Kippstufe es erlaubt, bei jedem Taktschritt, das Signal, welches daran an den Eingang angelegt ist, um eine Dauer, welche in Abhängigkeit von der Abtastperiode ($T_{éch}$) des eingehenden Impulssignals (s(t)) vorbestimmt ist, zu verzögern, und wobei ein Multiplizierer ($426_n$) durch mindestens ein Logikgatter "ET" gebildet ist.

6. Vorrichtung gemäß dem Anspruch 5, wobei das Impulssignal (s(t)) mit M Bits kodiert ist, wobei die Verzögerungsreihe, welche es erlaubt, ein Impulssignal zu verzögern, M Elementarverzögerungsreihen aufweist.

7. Vorrichtung gemäß irgendeinem der Ansprüche 1 bis 6, wobei das Analysemodul (220, 420) direkt das eingehende Impulssignal und/oder indirekt eine Anweisung (C), welche die Charakteristiken des Impulses des eingehenden Impulssignals (s(t)) angibt, nutzt.

8. Vorrichtung (220) gemäß irgendeinem der Ansprüche 1 bis 7, wobei ein zusätzliches Verzögerungsmodul ($214_0$) vorgesehen ist, um das eingehende Impulssignals (s(t)) um eine Dauer, welche einer Erstellungsdauer des Binärsignals (d(t)) zur Detektion durch das Analysemodul (220) entspricht, zu verzögern.

**Claims**

1. Device (210) for generating a carrier signal (p(t)) from an incident pulse signal (s(t)), said incident pulse signal comprising periodic pulses **characterised by** a pulse width (LI) and a repetition period (PRI), the device comprising:

- an analysis module (220) capable of generating a binary signal (d(t)) for detection of the pulse in the incident pulse signal (s(t)), said incident pulse signal (s(t)) being applied at the input of said analysis module;
- a multiplier (221) capable of weighting the incident pulse signal (s(t)) with the binary signal (d(t)) in order to obtain a weighted pulse signal which no longer has noise outside the pulse;
- a delay line (212) comprising K delay modules ($214_k$) arranged in series with one another, each delay module being capable of delaying an input pulse signal, applied at the input of said delay module, in order to deliver an output pulse signal corresponding to the input pulse signal delayed by a pulse width, the input pulse signal applied at the input of the first delay module of the delay line corresponding to the weighted pulse signal delivered at the output of the multiplier, and the number K of delay modules being equal to the integer part of the repetition period divided by the pulse width, decreased by one unit; and
- a summer (216) capable of summing the weighted pulse signal at the output of the multiplier and the K output pulse signals of the K delay modules of the delay line in order to obtain the carrier signal (p(t)).

2. Device (410) according to claim 1, wherein the delay line (412) comprises:

- a plurality of N basic cells ($418_n$) mounted in series with one another, each basic cell being capable of introducing a basic delay ($\tau_2$; $\delta\tau$) into an input signal applied at the input of said basic cell in order to deliver at the output a delayed output signal; and
- a plurality of N multipliers ($426_n$), the multiplier of rank n, n being an integer between 1 and N, allowing the output signal of the basic cell of rank n of the delay line (412) to be multiplied by a coefficient ($c_n$) of a plurality of N coefficients, each coefficient being determined by the analysis module (420) from the incident pulse signal (s(t)) so as to group together the basic cells to form said K delay modules ($414_k$) of the delay line.

3. Device (210') for generating a carrier signal (p(t)) from an incident pulse signal (s(t)), said incident pulse signal comprising periodic pulses **characterised by** a pulse width (LI) and a repetition period (PRI), the device comprising:

- an analysis module (220) capable of generating a binary signal (d(t)) for detection of the pulse in the incident pulse signal (s(t)), said incident pulse signal being applied at the input of said analysis module;
- a first delay line (212) dedicated to the incident pulse signal (s(t)) and comprising K delay modules ($214_k$) arranged in series with one another, each delay module being capable of delaying an input pulse signal, applied at the input of said delay module, in order to deliver an output pulse signal, at the output of said delay module, corresponding to the input pulse signal delayed by a pulse width, the input pulse signal applied at the input of the first delay module of the first delay line corresponding to the incident pulse signal (s(t)), and the number K of delay modules being equal to the integer part of the repetition period divided by the pulse width, decreased by one unit;
- a second delay line (222) dedicated to the binary signal (d(t)) and comprising K delay modules ($224_k$) arranged in series with one another, each delay module being capable of delaying a binary input signal, applied at the input of said delay module, in order to deliver a binary output signal, at the output of said delay module, corresponding to the binary input signal delayed by the pulse width, the binary input signal applied at the input of the first delay module of the second delay line corresponding to the binary signal delivered by the analysis module;
- a multiplier of rank 0 capable of weighting the incident pulse signal (s(t)) with the binary signal (d(t)) in order to obtain a weighted pulse signal which has no noise outside the pulse;
- a plurality of multipliers ($226_k$), the multiplier of rank k, k being an integer between 1 and K, capable of weighting the output pulse signal ($s_k$) delivered at the output of the delay module ($214_k$) of rank k of the first delay line with the binary output signal ($d_k$) delivered at the output of the delay module ($224_k$) of rank k of the second delay line, in order to obtain delayed weighted pulse signals which have no noise outside the pulse; and
- a summer (216) capable of summing the weighted pulse signal at the output of the multiplier of rank 0 and the K delayed weighted pulse signals at the output of the K multipliers of rank k in order to obtain the continuous carrier signal.

4. Device (410') according to claim 3, wherein each delay line (412; 422) comprises:

- a plurality of N basic cells ($418_n$; $428_n$) mounted in series with one another, each basic cell being capable of introducing a basic delay ($\tau_2$; $\delta\tau$) into an input signal, applied at the input of said basic cell, in order to deliver an output signal, at the output of said basic cell, which is delayed; and
- a plurality of N multipliers ($426_n$), the multiplier of rank n, n being an integer between 1 and N, allowing the output pulse signal ($s_n$) of the basic cell of rank n ($418_n$) of the first delay line (412) to be multiplied by the binary output signal ($d_n$) of the basic cell of rank n ($428_n$) of the second delay line (422) and by a coefficient ($c_n$) of a plurality of N coefficients, each coefficient ($c_n$) being determined by the analysis module (420) from the incident pulse signal (s(t)) so as to form said K delay modules ($414_k$; $424_k$) from the basic cells of the delay lines.

5. Device (410') according to claim 2 or claim 4, wherein a basic cell ($418_n$; $428_n$) is composed of at least a plurality of latches (10) mounted in series with one another, each latch allowing, at each clock step, the signal applied thereto at the input to be delayed by a duration which is predetermined as a function of the sampling period ($T_{éch}$) of the incident pulse signal (s(t)), and wherein a multiplier ($426_n$) is composed of at least one "AND" logic gate.

6. Device according to claim 5, wherein, the pulse signal (s(t)) being coded with M bits, the delay line allowing a pulse signal to be delayed comprises M basic delay lines.

7. Device according to any one of claims 1 to 6, wherein the analysis module (220, 420) uses directly the incident pulse signal and/or indirectly a reference value (C) which is indicative of characteristics of the pulse of the incident pulse signal (s(t)).

8. Device (220) according to any one of claims 1 to 7, wherein an additional delay module ($214_0$) is provided for delaying the incident pulse signal (s(t)) by a duration corresponding to a duration of establishment of the binary detection signal (d(t)) by the analysis module (220).

s(t), p(t)

LI

PRI

## FIG.1

112

s(t)

$-114_1-$  $-114_2-$  $-114_3-$  $S_{k-1}$  $-114_k-$  $S_k$  $-114_K-$

-116-

p(t)

110

## FIG.2

FIG.3

EP 3 516 769 B1

FIG.4

EP 3 516 769 B1

FIG.5

FIG.6

EP 3 516 769 B1

FIG.7

FIG.8

EP 3 516 769 B1

**FIG.9**

FIG.10

**EP 3 516 769 B1**

## RÉFÉRENCES CITÉES DANS LA DESCRIPTION

**Documents brevets cités dans la description**

- WO 2012038734 A1